Europäisches Patentamt

European Patent Office

Office européen des brevets

(11) Publication number: **0 356 571 B1**

# EUROPEAN PATENT SPECIFICATION

(45) Date of publication of patent specification: **19.02.92**   (51) Int. Cl.⁵: **G11C  16/06**

(21) Application number: **88114382.0**

(22) Date of filing: **02.09.88**

(54) **Control circuit for EEPROM.**

(43) Date of publication of application:
**07.03.90 Bulletin  90/10**

(45) Publication of the grant of the patent:
**19.02.92 Bulletin  92/08**

(84) Designated Contracting States:
**DE FR GB**

(56) References cited:
**US-A- 4 326 134**
**US-A- 4 488 060**

**IEEE JOURNAL OF SOLID-STATE CIRCUITS,
vol. SC-18, no. 5, October 1983, pages
532-538, IEEE, New York, US; D.H. OTO et al.:
"High-voltage regulation and process con-
siderations for high-density 5 V-only
E2PROM's"**

**ELECTRONICS & COMMUNICATIONS IN JA-
PAN, vol. 67-C, no. 5, May 1984, pages 91-99,
Scripta Publishing Co., Silver Spring, Mary-
land, US; Y. YATSUDA et al.: "A byte eras-
able 5V-only 64 Kbit EEPROM"**

(73) Proprietor: **Oki Electric Industry Company,
Limited
7-12, Toranomon 1-chome Minato-ku
Tokyo 105(JP)**

(72) Inventor: **Tanagawa, Kouzi c/o Oki Electric
Industry Co.,Ltd.
7-12, Toranomon 1-chome Minato-ku
Tokyo(JP)**

(74) Representative: **Betten & Resch
Reichenbachstrasse 19
W-8000 München 5(DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

BACKGROUND OF THE INVENTION

This invention relates to a control circuit for an EEPROM (Electrically Erasable Programmable Read Only Memory), more particularly to a control circuit generating a high voltage pulse enabling a rewrite function of EEPROM data with low voltage and low power consumption.

There are various kinds of EEPROMs available not only for use as a single unit but for constituting an one-chip microcomputer in combination with a microprocessor, which can be constructed as a CMOS structure.

A semiconductor integrated circuit in which the EEPROM is incorporated has a wide variety of applications such as replacement of a mechanical switch, an IC card having function which stores and adjusts operational procedures of a calculator or stores and refreshes data. (Ex. See NIKKEI ELECTRONICS, Oct. 21, 1985 P. 127)

Since the conventional EEPROM, however, employs a 5V power supply and needs a data rewrite cycle, it is difficult to be incorporated into the semiconductor integrated circuit utilized in watches, electric calculators, cameras, toys or IC cards driven by a solar cell.

Fig. 6 shows a block diagram of a control circuit for EEPROM with 5V single power supply operation generating a high voltage pulse for data write/erase/read.

The power supply voltage of 5V is applied to a clock pulse generation circuit 1 so that a clock pulse train having a frequency of 5-10MH$_z$ and a peak wave value 5V can be achieved.

When the clock pulse is applied to a voltage booster circuit 2, a step-up voltage of 23-25V can be output.

Fig. 7 shown an example of the conventional voltage booster circuit having 10-13 booster stages which are adequate for obtaining a step-up voltage of 20-25V from a source voltage of 5V.

The high voltage of 20-25V generated by the booster circuit 2 is applied to a regulator circuit 3 which stabilizes the high voltage to a constant level voltage.

Fig. 8(A) shows a concrete circuit of the regulator circuit, the output voltage of which is 18-20V in direct current (D.C.).

A wave shaping circuit 4 generates a high voltage pulse which is necessary to write/erase data of cells of the EEPROM.

The high voltage pulse requires a peak wave value of 18-20V and a constant rising rate, for example, 16V/ms.

When the rising rate is too sharp, the reliability of the cells of the EEPROM will be deteriorated.

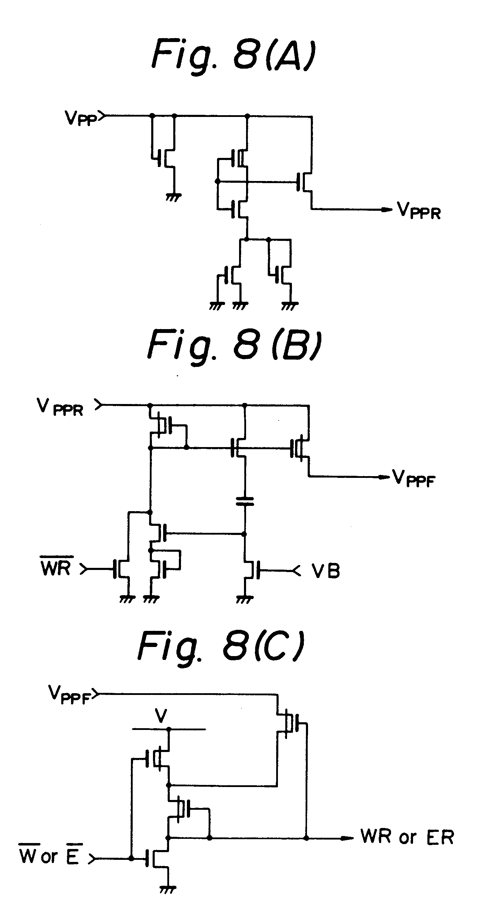

One embodiment of the concrete wave shaping circuit is shown in Fig. 8(B).

There is provided a high voltage switch circuit 5 to switch the high voltage pulse generated by the wave shaping circuit 4 to a writing direction or to an erasing direction, interchangeably.

Fig. 8(C) shows a concrete circuit of the high voltage switch circuit 5.

The high voltage pulse is switched interchangeably by the high voltage switch circuit 5 in such a manner that the high voltage pulse is applied to a drain electrode of the memory cell in accordance with a writing signal W in case of writing, whereas it is applied to a gate electrode of the memory cell in accordance with an erasing signal E on erasing.

A memory cell 6 is constituted by being arrayed a plurality of FETs with a double layer silicon gate structure comprising a source electrode , a drain electrode, a floating gate and a gate electrode.

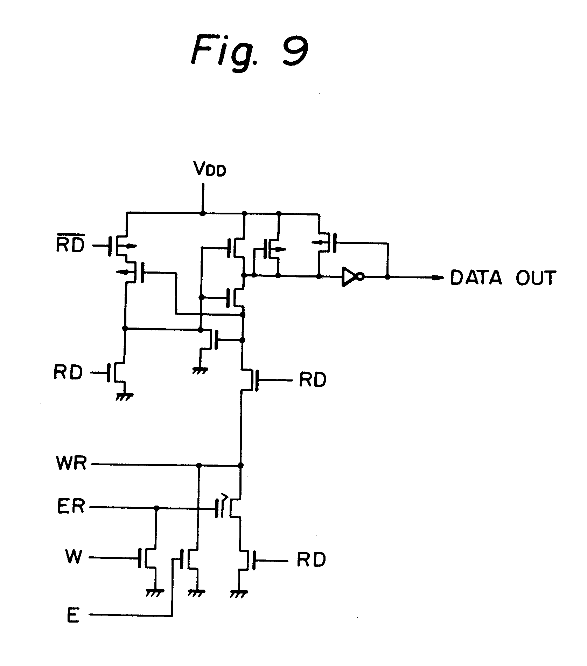

One embodiment of the concrete circuit is shown in Fig. 9.

The writing function to the memory cell 6 is performed such that the high voltage pulse is applied between the drain and the gate with the gate electrode being fixed to zero volt.

The erasing cycle is performed such that the high voltage pulse is applied between the gate and the drain with the drain electrode being fixed to zero volt.

A control circuit according to the preamble of claim 1 is known from "IEEE Journal of Solid-State Circuits", Vol. SC 18, No. 5, October 1983, pages 532 to 538. The known circuit relates to a voltage booster and a high voltage shaping switch which are operated by a supply voltage of 5 V.

SUMMARY OF THE INVENTION

An object of the present invention is to provide a control circuit for an EEPROM which enables writing and erasing data to the EEPROM with low voltage of an approximate 1.5V and low current less than a few hundred μA.

To accomplish the above object, there is provided a control circuit according to claim 1.

Further, the high voltage switch circuit having an exponential rising pulse edge requires no special wave shaping circuit so that a simplified and low voltage operated circuit can be achieved.

BRIEF DESCRIPTION OF THE DRAWINGS

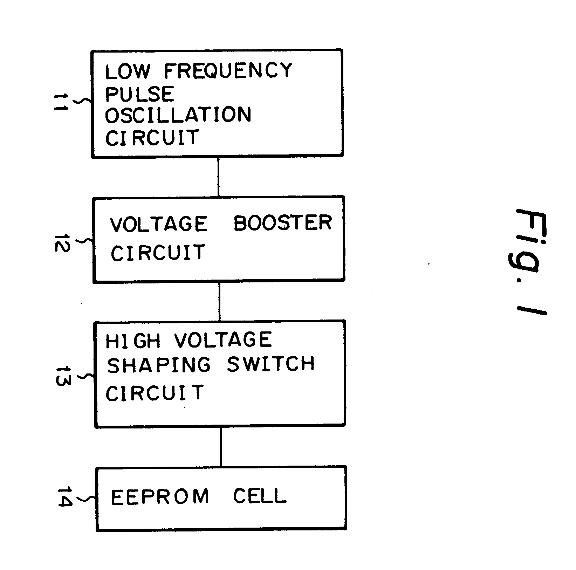

Fig. 1 is a block diagram of a control circuit for an EEPROM illustrating one embodiment according to the present invention.

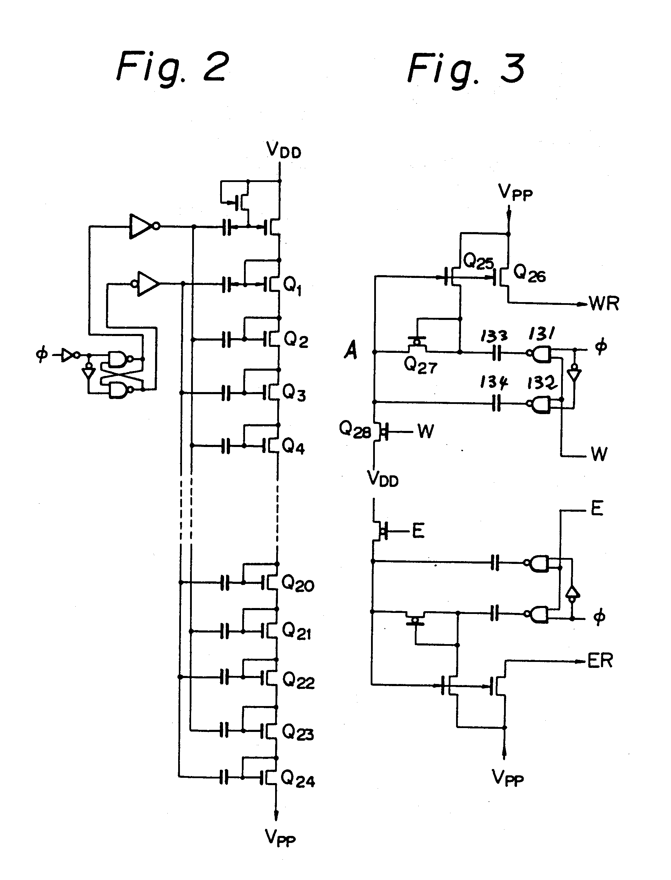

Fig. 2 is a circuit diagram of a booster circuit utilized in one embodiment of the invention.

Fig. 3 is a circuit diagram of a high voltage shaping switch circuit utilized in one embodiment of the invention.

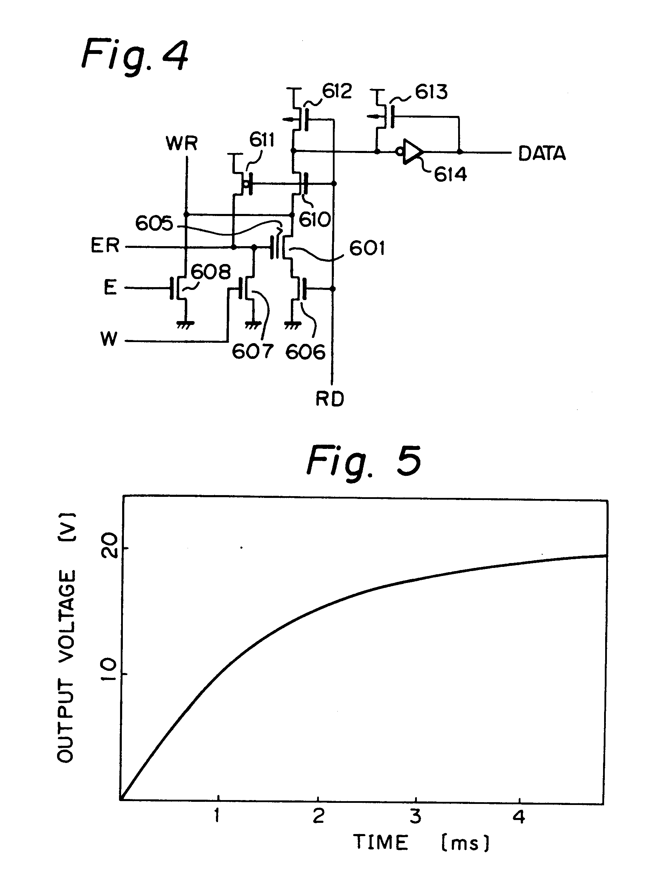

Fig. 4 is a circuit diagram of a memory cell and a read-out circuit thereof utilized in one embodiment of the invention.

Fig. 5 is a wave form chart of a high voltage pulse showing a rising edge of the pulse according to the invention.

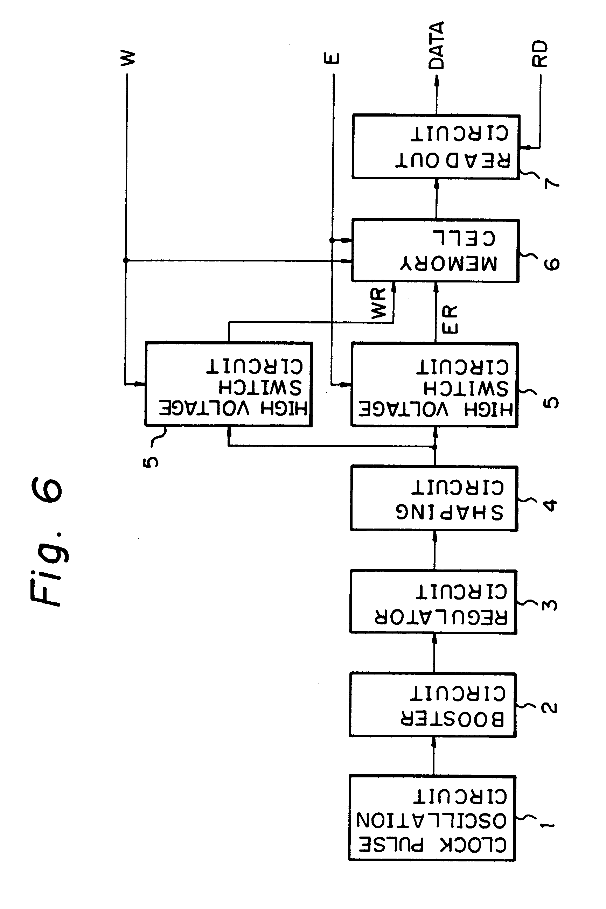

Fig. 6 is a block diagram of a conventional EEPROM.

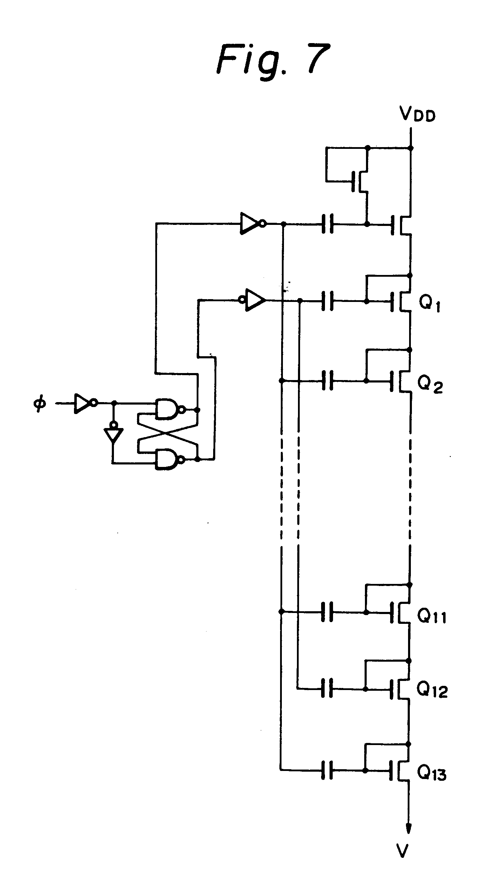

Fig. 7 is a circuit diagram of a conventional booster circuit.

Fig. 8(A), Fig. 8(B) and Fig. 8(C) are circuit diagrams of a conventional regulator circuit, a shaping circuit and a high voltage switch circuit, respectively.

Fig. 9 is a circuit diagram of a conventional memory cell and a read-out circuit thereof.

## DETAILED DESCRIPTION OF THE EMBODIMENT

Referring to Fig. 1, the control circuit for the EEPROM according to the present invention comprises a low frequency pulse oscillation circuit 11, a voltage booster circuit 12, and a high voltage shaping switch circuit 13.

The low frequency clock pulse oscillation circuit 11 is an oscillator generating an approximate 30KHz frequency driven by low voltage and low current.

It is essential to lower the frequency of the clock pulse for reducing power consumption of the whole control circuit.

The adequate frequency range for the clock pulse lies between 20KHz and 100KHz. The present embodiment shows an oscillator operating with a 1.5V source voltage and a few $\mu$A consumption current.

The voltage booster circuit 12 is a booster circuit with low power consumption which operates with low power source driven by the oscillation circuit 11.

Though a conventional booster circuit has approximately 10 stages, the present invention employs at least 19 stages, particularly in the present embodiment 24 stages, to operate with low power voltage of an approximate 1.5V.

Fig. 2 shows a circuit diagram of the voltage booster circuit 12 in accordance with the present embodiment.

Transistors Q1 - Q24 constitute the booster stages, each of which is constituted by zero threshold FETs.

The zero threshold FET is a FET where the threshold voltage is controlled to be nearly zero volt (approximately $0 \pm 0.4$V).

Utilization of the zero threshold voltage FET in the booster stage enables to elevate voltage efficiently without voltage loss.

In this embodiment, an approximate 20V high voltage necessary for writing and erasing of the EEPROM can be obtained as an output voltage $V_{pp}$ about 20ms later after the clock is supplied under conditions of the power source voltage $V_{DD}$ being 1.5V, the booster stage being 24 and the clock frequency being 30KHz.

In this voltage booster circuit, as long as a clock is applied thereto, the output voltage $V_{pp}$ of about 24V in D. C. can be obtained.

The voltage booster circuit according to the present invention employs at least 19 stage zero threshold FETs and is driven by the low voltage power source $V_{DD}$ having an approximate 1.5V and the slow clock having an approximate 30KHz so that the output voltage $V_{pp}$ having an approximate 20V which is adequate for writing and erasing of the cell of the EEPROM can be obtained.

Accordingly, a regulator circuit which is used in the conventional circuit is not necessarily required because the voltage booster circuit has the same function.

The high voltage shaping switch circuit 13 is a circuit which forms a high voltage pulse needed for data writing and erasing of the memory cell 14 by using the approximate 20V achieved by the booster circuit 12.

Fig. 3 shows an embodiment of the circuit.

When a writing signal W is to be "1", a high voltage WR for writing can be formed from the D. C. voltage $V_{pp}$ by the functions of transistors $Q_{25}$, $Q_{26}$ and $Q_{27}$ and two capacitors.

This high voltage pulse is of an exponential type which has a 1-5 ms rising edge due to the function of transistor and capacitor of 1-2pF when driven by the clock pulse of an approximate 30KHz.

Fig. 5 shows a wave form chart illustrating the rising edge of the pulse.

The exponential type pulse is particularly suitable with an approximate 1 ms rising edge.

The memory cell 14 itself is the same type as the conventional one arrayed by FETs for data storage having source-drain electrodes, a floating gate and a normal gate.

Now, the writing and the erasing functions will be explained referring to Fig. 4.

In case of writing, after the switch circuit is activated by the writing signal W being "1", the high voltage pulse is applied to the drain of the memory cell FET 601 and the gate of the FET 601 is simultaneously grounded to zero by the transistor 607.

Then, electrons stored in the floating gate 605 are transferred through the drain so that positive electric charges are accumulated in the floating gate.

In case of erasing, after the switch circuit is activated by the erasing signal E being "1", the high voltage pulse is applied to the gate of the memory cell FET 601 and the gate of the FET 601 is simultaneously grounded to zero by the transistor 608.

Then, electrons are injected to the floating gate causing negative charging up.

In other words, the positive electric charges injected in writing cycle are erased and further negative charges are accumulated.

Now, data read-out operation will be explained.

First, a read-out signal RD is set to be "1".

Then, an approximate 1.3V read-out voltage is applied through the zero threshold FET 611 to the gate of the memory cell FET.

In the event that the memory cell is being written, namely, the floating gate is being positively charged, the memory cell FET 601 becomes conductive between the source and the drain so that the drain current flows through the FETs 610, 601 and 606.

Then, an inverter 614 and a FET 613 read out date "1".

In the event that the memory cell is being erased, namely, the floating gate is being negatively charged, the memory cell FET 601 does not become conductive so that the drain current does not flow through the FETs 610, 601 and 606.

Then, the inverter 614 and the FET 613 read out date "0".

## Claims

1. A control circuit generating a write/erase high voltage pulse for an EEPROM, the control circuit comprising a pulse oscillation circuit (11), a voltage booster circuit (12) having a plurality of booster stages each of which has a FET being driven by the clock pulse, and a high voltage shaping switch circuit (13) comprising a first transistor ($Q_{25}$) having a first terminal connected to an output terminal of the voltage booster circuit (12), a second terminal and a control terminal connected to a node (A), a second transistor ($Q_{27}$) having a first terminal connected to the node (A), a second terminal connected to the second terminal of the first transistor ($Q_{25}$) and a control terminal connected to the second terminal of the first transistor ($Q_{25}$), and a first capacitor (133) one terminal of which is connected with the second terminal of the first transistor ($Q_{25}$), characterized in that the clock pulse oscillation circuit (11) generates a low frequency clock pulse ($\phi$), the high voltage shaping switch circuit (13) comprises
   - a first NAND gate (131) having a first input terminal to receive the clock pulse ($\phi$), a second input terminal to receive a writing/erasing signal (W) and an output terminal,
   - a second NAND gate (132) having a first input terminal to receive inverse pulse of the clock pulse ($\phi$), a second input terminal to receive the writing/erasing signal (W) and an output terminal,
   - a third transistor ($Q_{26}$) having a first terminal connected to the output terminal of the voltage booster circuit (12), a second terminal supplying the write/erase high voltage pulse (WR) and a control terminal connected to the node (A), and
   - a second capacitor (134) connected between the output terminal of the second NAND gate (132) and the node (A), wherein the other terminal of the first capacitor (133) is connected to the output terminal of the first NAND gate (131), and that the voltage booster circuit (12) comprises at least 19 stages.

2. A control circuit according to claim 1 wherein the low frequency clock pulse is approximately 30 KHz.

3. A control circuit according to claim 1 wherein the low voltage of the low power voltage source ($V_{DD}$) is approximately 1.5V.

4. A control circuit according to claim 1 wherein the capacitance of the first and the second capacitors (133, 134) is approximately 1 to 2pF.

5. A control circuit according to claim 1 wherein the FET has a threshold voltage selected to be nearly zero volt.

6. A control circuit according to claim 1 wherein the high voltage shaping switch circuit (13) further comprises a fourth transistor ($Q_{28}$) connected between a low voltage power source ($V_{DD}$) and the node (A), the fourth transistor ($Q_{28}$) having a control terminal to receive the writing/erasing signal (W).

## Revendications

1. Circuit de commande générant une impulsion de haute tension d'écriture/effacement pour une EEPROM, le circuit de commande comportant un circuit oscillant (11) à impulsions, un circuit survolteur (12) comportant plusieurs étages survolteurs ayant chacun un TEC attaqué par l'impulsion d'horloge, et un circuit de commutation conformateur de haute tension (13) comprenant

    un premier transistor ($Q_{25}$) ayant une première borne connectée à une borne de sortie du circuit survolteur (12), une seconde borne et une borne de commande connectées à un noeud (A),

    un second transistor ($Q_{27}$) ayant une première borne connectée au noeud (A), une seconde borne connectée à la seconde borne du premier transistor ($Q_{25}$) et une borne de commande connectée à la seconde borne du premier transistor ($Q_{25}$),

    et un premier condensateur (133) dont une borne est connectée à la seconde borne du premier transistor ($Q_{25}$),

    caractérisé en ce que

    le circuit oscillant (11) à impulsions d'horloge génère une impulsion d'horloge ($\phi$) à basse fréquence,

    le circuit de commutation conformateur de haute tension (13) comporte

- une première porte NON-ET (131) ayant une première borne d'entrée destinée à recevoir l'impulsion d'horloge ($\phi$), une seconde borne d'entrée destinée à recevoir un signal d'écriture/effacement (W) et une borne de sortie,
- une seconde porte NON-ET (132) ayant une première borne d'entrée destinée à recevoir une impulsion inverse de l'impulsion d'horloge ($\phi$), une seconde borne d'entrée destinée à recevoir le signal d'écriture/effacement (W) et une borne de sortie,
- un troisième transistor ($Q_{26}$) ayant une première borne connectée à la borne de sortie du circuit survolteur (12), une seconde borne fournissant l'impulsion à haute tension d'écriture/effacement (WR) et une borne de commande connectée au noeud (A), et
- un second condensateur (134) connecté entre la borne de sortie de la seconde porte NON-ET (132) et le noeud (A), l'autre borne du premier condensateur (133) étant connectée à la borne de sortie de la première porte NON-ET (131),

et en ce que le circuit survolteur (12) comporte au moins 19 étages.

2. Circuit de commande selon la revendication 1, dans lequel l'impulsion d'horloge à basse fréquence est d'approximativement 30 kHz.

3. Circuit de commande selon la revendication 1, dans lequel la basse tension de la source de tension à basse puissance ($V_{DD}$) est d'environ 1,5 V.

4. Circuit de commande selon la revendication 1, dans lequel la capacité des premier et second condensateurs (133, 134) est d'environ 1 à 2 pF.

5. Circuit de commande selon la revendication 1, dans lequel le TEC a une tension de seuil choisie de façon à être au voisinage de zéro volt.

6. Circuit de commande selon la revendication 1, dans lequel le circuit de commutation conformateur de haute tension (13) comporte en outre un quatrième transistor ($Q_{28}$) connecté entre une source d'énergie à basse tension ($V_{DD}$) et le noeud (A), le quatrième transistor ($Q_{28}$) ayant une borne de commande destinée à recevoir le signal d'écriture/effacement (W).

**Patentansprüche**

1. Steuerschaltung, die einen Schreib/Lösch-Impuls mit hoher Spannung für einen EEPROM erzeugt und folgendes aufweist: einen Impulsschwingkreis (11), eine Spannungs-Booster-Schaltung (12) mit einer Vielzahl von Booster-Stufen, von denen jede einen durch den Taktimpuls getriebenen FET-Transistor hat, und eine Schaltung zur Formung des Impulses hoher Spannung (13), die folgendes aufweist:
einen ersten Transistor ($Q_{25}$) mit einem ersten, mit einem Ausgangsanschluß der Spannungs-Booster-Schaltung (12) verbundenen Anschluß, einem zweiten Anschluß und einem mit einem Knotenpunkt (A) verbundenen Steueranschluß,
einen zweiten Transistor ($Q_{27}$) mit einem ersten, mit dem Knotenpunkt (A) verbundenen Anschluß, einem zweiten, mit dem zweiten Anschluß des ersten Transistors ($Q_{25}$) verbundenen Anschluß und einem mit dem zweiten Anschluß des ersten Transistors ($Q_{25}$) verbundenen Steueranschluß,
und einen ersten Kondensator (133), dessen einer Anschluß mit dem zweiten Anschluß des ersten Transistors ($Q_{25}$) verbunden ist,
dadurch gekennzeichnet, daß
der Taktimpulsschwingkreis (11) einen niederfrequenten Taktimpuls ($\phi$) erzeugt,
die Schaltung zur Formung des Impulses hoher Spannung (13) folgendes aufweist:
- ein erstes NAND-Glied (131) mit einem ersten Eingangsanschluß zum Empfangen des Taktimpulses ($\phi$), einem zweiten

Eingangsanschluß zum Empfangen eines Schreib/Lösch-Signals (W), und einem Ausgangsanschluß,
- ein zweites NAND-Glied (132) mit einem ersten Eingangsanschluß zum Empfangen des zum Taktimpuls ($\phi$) inversen Impulses, einem zweiten Eingangsanschluß zum Empfangen des Schreib/Lösch-Signals (W), und einem Ausgangsanschluß,
- einen dritten Transistor ($Q_{26}$) mit einer ersten, mit dem Ausgangsanschluß der Spannungs-Booster-Schaltung (12) verbundenen Anschluß, einem zweiten, den Schreib/Lösch-Impuls hoher Spannung (WR) liefernden Anschluß und einem mit dem Knotenpunkt (A) verbundenen Steueranschluß, und
- einen zweiten, zwischen dem Ausgangsanschluß des zweiten NAND-Glieds (132) und dem Knotenpunkt (A) geschalteten Kondensator (134), wobei der andere Anschluß des ersten Kondensators (133) mit dem Ausgangsanschluß des ersten NAND-Glieds (131) verbunden ist,
und daß die Spannungs-Booster-Schaltung (12) mindestens 19 Stufen aufweist.

2. Steuerschaltung nach Anspruch 1, worin der niederfrequente Takt ungefähr 30 kHz beträgt.

3. Steuerschaltung nach Anspruch 1, worin die Spannung der Spannungsquelle niedriger Spannung ($V_{DD}$) ungefähr 1,5 V beträgt.

4. Steuerschaltung nach Anspruch 1, worin die Kapazität des ersten und zweiten Kondensators (133, 134) ungefähr 1 bis 2 pF beträgt.

5. Steuerschaltung nach Anspruch 1, worin der FET-Transistor eine Schwellenspannung hat, die so ausgewählt ist, daß sie fast 0 Volt beträgt.

6. Steuerschaltung nach Anspruch 1, worin die Schaltung zur Formung des Impulses hoher Spannung (13) weiterhin einen vierten, zwischen einer Spannungsquelle niedriger Spannung ($V_{DD}$) und dem Knotenpunkt (A) geschalteten Transistor ($Q_{28}$) aufweist, wobei der vierte Transistor ($Q_{28}$) einen Steueranschluß zum Empfang des Schreib/Lösch-Signals (W) hat.

# Fig. 1

LOW FREQUENCY PULSE OSCILLATION CIRCUIT — 11

VOLTAGE BOOSTER CIRCUIT — 12

HIGH VOLTAGE SHAPING SWITCH CIRCUIT — 13

EEPROM CELL — 14

# Fig. 2

# Fig. 3

EP 0 356 571 B1

# Fig. 4

# Fig. 5

9

# Fig. 6

Fig. 6 — Block diagram: CLOCK PULSE OSCILLATION CIRCUIT (1) → BOOSTER CIRCUIT (2) → REGULATOR CIRCUIT (3) → SHAPING CIRCUIT (4) → HIGH VOLTAGE SWITCH CIRCUIT (5) with signals WR, ER; inputs W, E; HIGH VOLTAGE SWITCH CIRCUIT (5) → MEMORY CELL (6) → READOUT CIRCUIT (7) → DATA, RD.

# Fig. 7

## Fig. 8(A)

## Fig. 8 (B)

## Fig. 8(C)

# Fig. 9

DATA OUT